# EUROPÄISCHE PATENTSCHRIFT

(11) **EP 0 782 173 B1**
(45) Veröffentlichungstag und Bekanntmachung des Hinweises auf die Patenterteilung: **16.08.2006**
(21) Anmeldenummer: 96111651.4
(22) Anmeldetag: 19.07.1996
(51) Int. Cl.: H01J 37/34, C23C 14/40, C23C 14/35, C23C 14/00, C23C 14/56, C23C 16/50, H01J 37/32

(54) **Vorrichtung zum Beschichten eines Substrats mit Hilfe des Chemical-Vapor-Deposition-Verfahrens**
Apparatus for coating a substrate by means of a chemical vapour deposition process
Dispositif pour le revêtement d'un substrat utilisant un procédé de dépôt chimique en phase vapeur

(30) Priorität: 31.10.1995 DE 19540543
(43) Veröffentlichungstag der Anmeldung: 02.07.1997
(73) Patentinhaber: Unaxis Deutschland Holding GmbH, 80331 München (DE)
(72) Erfinder: Szczyrbowski, Joachim, Dr., 63733 Goldbach (DE); Teschner, Götz, 63450 Hanau (DE)

(56) Entgegenhaltungen:
- EP-A- 0 502 242
- EP-A- 0 510 401
- EP-A- 0 544 107
- DE-A- 4 237 517
- DE-A- 4 239 843
- DE-A- 4 326 100

## Beschreibung

Die Erfindung betrifft eine Vorrichtung zum Beschichten eines Substrats mit Hilfe von Plasma-CVD, bestehend aus einer Wechselstromquelle, beispielsweise einem Mittelfrequenzgenerator, der mit zwei Magnete einschließenden Kathoden verbunden ist, die elektrisch mit Targets zusammenwirken, die zerstäubt werden, wobei der eine Pol der Wechselstromquelle an die eine Kathode und der andere Pol an die andere Kathode jeweils über eine Versorgungsleitung angeschlossen sind.

Es ist bereits eine Zerstäubungseinrichtung zur Herstellung dünner Schichten bekannt (DD 252 205), bestehend aus einem Magnetsystem und mindestens zwei darüber angeordneten Elektroden aus dem zu zerstäubenden Material, wobei diese Elektroden elektrisch so gestaltet sind, daß sie wechselweise Kathode und Anode einer Gasentladung sind. Die Elektroden sind zu diesem Zwecke an eine sinusförmige Wechselspannung von vorzugweise 50 Hz angeschlossen.

Diese bekannte Zerstäubungseinrichtung soll besonders für die Abscheidung dielektrischer Schichten durch reaktive Zerstäubung geeignet sein. Durch den Betrieb der Einrichtung mit etwa 50 Hz soll vermieden werden, daß es zur Flitterbildung an der Anode und im Falle von Metallbeschichtung zu elektrischen Kurzschlüssen (sogenannten Arcs) kommt.

Bei einer anderen bereits bekannten Vorrichtung zum Aufstäuben eines dünnen Films, bei der die Geschwindigkeit des Niederbringens von Schichten unterschiedlicher Materialien regelbar ist (DE 39 12 572), um so zu extrem dünnen Schichtpaketen zu gelangen, sind mindestens zwei unterschiedliche Arten von kathodenseitig vorgesehenen Gegenelektroden angeordnet.

Weiterhin ist eine Anordnung zum Abscheiden einer Metallegierung mit Hilfe von HF-Kathodenzerstäubung bekannt (DE 35 41 621), bei der abwechselnd zwei Targets angesteuert werden, wobei die Targets die Metallkomponenten der abzuscheidenden Metallegierung jedoch mit unterschiedlichen Anteilen enthalten. Die Substrate sind zu diesem Zweck auf einem Substratträger angeordnet, der von einer Antriebseinheit während des Zerstäubungsvorgangs in Rotation versetzt wird.

Durch eine vorveröffentlichte Druckschrift (DE 38 02 852) ist es außerdem bekannt, bei einer Einrichtung für die Beschichtung eines Substrats mit zwei Elektroden und wenigstens einem zu zerstäubenden Material das zu beschichtende Substrat zwischen den beiden Elektroden in einem räumlichen Abstand anzuordnen und die Wechselstrom-Halbwellen als niederfrequente Halbwellen mit im wesentlichen gleichen Amplituden zu wählen.

Weiterhin sind ein Verfahren und eine Vorrichtung beschrieben (DOS 41 06 770) zum reaktiven Beschichten eines Substrats mit einem elektrisch isolierenden Werkstoff, beispielsweise mit Siliziumdioxid (SiO₂), bestehend aus einer Wechselstromquelle, die mit in einer Beschichtungskammer angeordneten Magnete einschließende Kathoden verbunden ist, die mit Targets zusammenwirken, wobei zwei erdfreie Ausgänge der Wechselstromquelle mit je einer ein Target tragenden Kathode verbunden sind, wobei beide Kathoden in der Beschichtungskammer nebeneinanderliegend in einem Plasmaraum vorgesehen sind und zum gegenüberliegenden Substrat jeweils etwa den gleichen räumlichen Abstand aufweisen. Der Effektivwert der Entladespannung wird dabei von einer über eine Leitung an die Kathode angeschlossenen Spannungseffektivwerterfassung gemessen und als Gleichspannung einem Regler über eine Leitung zugeführt, der über ein Regelventil den Reaktivgasfluß vom Behälter in die Verteilerleitung so steuert, daß die gemessene Spannung mit einer Sollspannung übereinstimmt.

Schließlich ist eine Vorrichtung zum Beschichten eines Substrats, insbesondere mit nichtleitenden Schichten von elektrisch leitfähige Targets in reaktiver Atmosphäre bekannt (DE 4 237 517 und DE 42 04 999), bestehend aus einer Stromquelle, die mit in einer evakuierbaren Beschichtungskammer angeordneten, Magnete einschließenden Kathoden verbunden ist, die elektrisch mit den Targets zusammenwirken, wobei zwei elektrisch voneinander und von der Sputterkammer getrennte Anoden angeordnet sind, die in einer Ebene zwischen den Kathoden und dem Substrat vorgesehen sind, wobei die beiden Ausgänge der Sekundärwicklung eines mit einem Mittelfrequenzgenerator verbundenen Transformators jeweils an eine Kathode über Versorgungsleitungen angeschlossen sind, wobei die erste und die zweite Versorgungsleitung über eine Zweigleitung untereinander verbunden sind, in die ein Schwingkreis, vorzugsweise eine Spule und ein Kondensator, eingeschaltet sind, und wobei jede der beiden Versorgungsleitungen jeweils sowohl über ein das Gleichspannungspotential gegenüber Erde einstellendes erstes elektrisches Glied mit der Beschichtungskammer als auch über ein entsprechendes zweites elektrisches Glied mit der jeweiligen Anode und über jeweils eine Zweigleitung mit eingeschaltetem Kondensator mit der Beschichtungskammer verbunden ist und wobei eine Drosselspule in den den Schwingkreis mit dem zweiten Sekundäranschluß verbindenen Abschnitt der ersten Versorgungsleitung eingeschaltet ist.

Während die bekannten Vorrichtungen sich damit befassen, das "Arcing", d.h. die Bildung unerwünschter Lichtbögen zu verhindern und die Oberfläche der Targets vor der Bildung isolierender Schichten zu bewahren, soll der Gegenstand der vorliegenden Erfindung geeignet sein, in Plasma-Chemical-Vapor-Deposition-Anlagen ein großflächiges, gleichmäßiges und dichtes Plasma zu erzeugen.

Gemäß der vorliegenden Erfindung wird diese Aufgabe dadurch gelöst, daß jede Kathode in einer eigenen Kammer oder Abteil angeordnet ist und beide Abteile ein drittes, an eine Vakuumquelle angeschlossenes Abteil zwischen sich einschließen und jeweils über Öffnungen oder Spalte, in den die Abteile voneinander abtrennenden Wände miteinander verbunden sind, wobei das im dritten Abteil gehaltene Substrat auf eine CVD-Quelle ausgerichtet ist, die aus einem Reaktivgaseinlaß und einem Kollimator gebildet ist.

Weitere Einzelheiten und Merkmale sind in den Patentansprüchen näher erläutert und gekennzeichnet.

Die Erfindung läßt die verschiedensten Ausführungsmöglichkeiten zu; zwei davon sind in den anliegenden Zeichnungen an Hand zweier Beschichtungsanlagen für flache Substrate schematisch näher dargestellt.

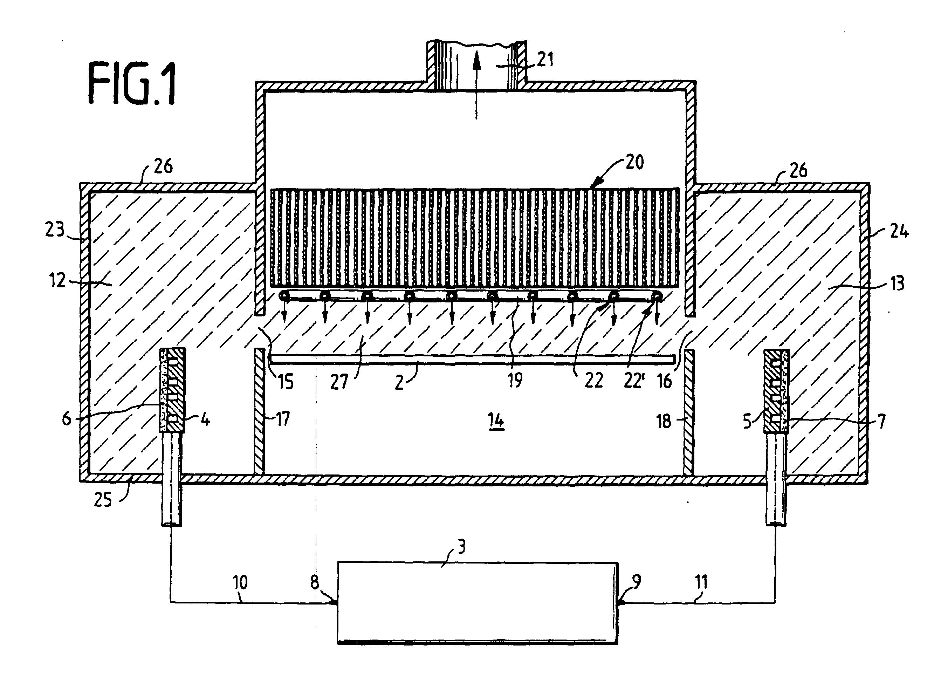

Die Vorrichtung gemäß Figur 1 besteht aus einer großen Vakuumkammer, die in drei Abteile 12,13,14 aufgeteilt ist, wobei die drei Abteile über die Spalte 15,16 in den Wänden 17,18, die diese Abteile voneinander abtrennen, verbunden sind. Das größere der drei Abteile 14 weist einen gitterförmigen Reaktivgaseinlaß 19 auf, der mit zahlreichen Auslaßdüsen 22,22',... versehen ist, über die das Prozeßgas auf das plattenförmige Substrat 2 strömen kann, wobei sich die Substratebene parallel zur Ebene des Reaktivgaseinlasses 19 erstreckt. Oberhalb des Reaktivgaseinlasses 19 ist ein Kollimator 20 angeordnet zum Zwecke der Homogenisierung der Gasströmungen über dem Substrat 2. Über den Kollimator 20 wird der Reaktionsraum 27 evakuiert. Der Kollimator selbst ist aus einer Vielzahl von einzelnen Rohren gebildet, die sämtlich parallel zueinander angeordnet sind und zusammen eine Art Gitter bilden. Bei 21 ist die Vakuumpumpe angeschlossen, über die alle drei Abteile 12,13,14 evakuiert werden. In jedem der beiden seitlich angeordneten Abteile 12,13 ist eine Kathode 4,5 vorgesehen, deren Targets 6,7 den Seitenwänden 23,24 zugekehrt sind. Jede der beiden Kathoden 4,5 ist über eine Leitung 10 bzw. 11 mit dem Mittelfrequenzgenerator 3 verbunden. Während des Sputterbetriebs breitet sich eine Plasmawolke aus, die die Abteile 12,13 und insbesondere auch den Raektionsraum 27 ausfüllt, so daß eine Abscheidung von verschleiß- und/oder korrosionsschützenden Schichten durch chemische Abscheidung aus der Gasphase auf dem Substrat 2 erfolgt, wenn das Prozeßgas in Pfeilrichtung aus den Düsen 22,22',... austritt.

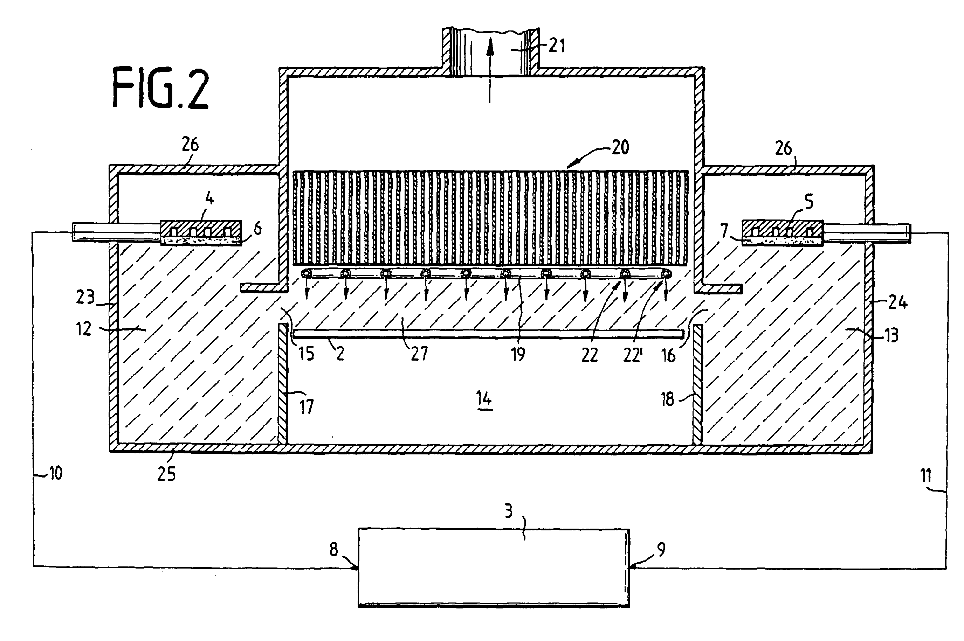

Das Ausführungsbeispiel nach Figur 2 unterscheidet sich von demjenigen nach Figur 1 nur dadurch, daß die Kathoden 4,5 mit ihren Targets 6,7 auf die Bodenteile 25 der Abteile 12,13 ausgerichtet sind. Bei beiden Ausführungsformen sind die Kathoden 4,5 mit einer gegen die Abteilwände 23,24 bzw. 25,26 floatenden Wechselspannung betrieben, wobei sich ein Plasma zwischen den beiden Targets 6,7 ausbildet und den volle Entladestrom des Magnetrons führt.

Die beschriebenen Vorrichtungen weisen folgende Vorteile auf:
1. Der Plasmaerzeugungsraum ist vom CVD-Reaktionsraum 27 getrennt, so daß die Ablagerungen auf den Elektroden (hier die Targets der Magnetrons), wesentlich verringert werden.
2. Durch die Trennung der Plasmaerzeugung vom Reaktionsraum 27 ist es möglich, die Elektronen und Ionen hoher Energie von dem CVD-Reaktionsraum fernzuhalten. Die Elektronen und Ionen hoher Energie sind besonders bei der Beschichtung von Kunststoffen unerwünscht, da die an der Oberfläche liegenden Polymerketten durch Ladungsträgebeschuß zerstört werden.
3. Der in diesem Falle unerwünschte Sputtereffekt der Magnetrons 4,5 ist nicht nachteilig, da die abgesputterten Teilchen in den abgetrennten Plasmaerzeugungsräumen bzw. Abteilen 12,13 aufgefangen werden, weshalb die Schichten auf den Substraten nicht verunreinigt werden können.
4. Durch die Verwendung von Magnetrons 4,5 ist die Plasmadichte um den Faktor 10 höher gegenüber Anordnungen ohne Magnetrons.
5. Das Plasmaband führt, wie oben angeführt, den vollen Entladestrom. Damit wird im Gegensatz zu allen anderen Anordnungen das stromstarke Plasma direkt an den Substraten 2 vorbeigeführt. Es ist möglich, die Substrate 2 direkt im Strom anzuordnen.

### Bezugszeichenliste

- 2: Substrat
- 3: Wechselstromquelle, Mittelfrequenz-Generator
- 4: Kathode
- 5: Kathode
- 6: Target
- 7: Target
- 8: Pol
- 9: Pol
- 10: Versorgungsleitung
- 11: Versorgungsleitung
- 12: Kammer, Abteil
- 13: Kammer, Abteil
- 14: Kammer, Abteil
- 15: Öffnung, Spalte
- 16: Öffnung, Spalte
- 17: Trennwand
- 18: Trennwand
- 19: Reaktivgaseinlaß
- 20: Kollimator
- 21: Vakuumquelle, Pumpe
- 22, 22', ...: Düse
- 23: Seitenwand des Abteils
- 24: Seitenwand des Abteils
- 25: Bodenteil
- 26: Deckelteil
- 27: Reaktionsraum

## Patentansprüche

1. Vorrichtung zum Beschichten eines Substrats (2) mit Hilfe von Plasma CVD, bestehend aus einer Wechselstromquelle (3), beispielsweise einem Mittelfrequenz-Generator, wobei die Wechselstromquelle mit zwei Magnete einschließenden Kathoden (4,5) verbunden ist, die elektrisch mit Targets (6,7) zusammenwirken, wobei der eine Pol (8) der Wechselstromquelle (3) an die eine Kathode (4) und der andere Pol (9) an die andere Kathode (5) jeweils über eine Versorgungsleitung (10,11) angeschlossen sind, **dadurch gekennzeichnet, daß** jede der beiden Kathoden (4,5) in einer eigenen Kammer oder Abteil (12,13) angeordnet ist und beide Abteile ein drittes, an eine Vakuumquelle (21) angeschlossenes Abteil (14) zwischen sich einschließen und jeweils über Öffnungen (15,16) oder Spalte in den die Abteile (12,14 bzw. 13,14) voneinander abtrennenden Wänden (17,18) miteinander verbunden sind, wobei das im dritten Abteil (14) angeordnete Substrat (2) auf eine CVD-Quelle ausgerichtet ist, die im wesentlichen aus einem Reaktivgaseinlaß (19) und einem Kollimator (20) gebildet ist.

2. Vorrichtung nach Anspruch 1, **dadurch gekennzeichnet, daß** der Reaktivgaseinlaß (19) der CVD-Quelle aus einem aus Rohren gebildeten Gitter mit auf das Substrat (2) ausgerichteten Düsen (22,22',...) gebildet ist und das Gitter in einer zur Ebene des Substrats (2) parallelen Ebene gehalten ist, wobei die Spalte (15,16) in den Trennwänden (17,18) in den vom Gitter und dem Substrat (2) gebildeten Zwischenraum (27) einmünden und die Targets (6,7) der Kathoden (4,5) in den beiderseits des Abteils (14) angeordneten Abteilen (12,13) auf die den Trennwänden (17,18) gegenüberliegenden Seitenwände (23,24) oder dem Boden- oder dem Deckelteil (25 bzw. 26) ausgerichtet sind.

## Claims

1. Device for coating a substrate (2) using plasma CVD, comprising an alternating current source (3) for example a medium frequency generator, where the alternating current source is connected with two cathodes (4, 5) enclosing magnets and cooperating electrically with targets (6, 7), where the one pole (8) of the AC source (3) is connected to the one cathode (4) and the other pole (9) to the other cathode (5) in each case via a supply line (10, 11), **characterised in that** each of the two cathodes (4, 5) is arranged in its own compartment or chamber (12, 13) and the two compartments enclose between them a third compartment (14) connected to a vacuum source (21) and are connected together in each case via openings (15, 16) or gaps in the walls (17, 18) separating the compartments (12, 14 or 13, 14) from each other, where the substrate (2) arranged in the third compartment (14) is oriented to a CVD source which is essentially formed from a reactive gas inlet (19) and a collimator (20).

2. Device according to claim 1, **characterised in that** the reactive gas inlet (19) of the CVD source is formed by a grid made of tubes with nozzles (22,22', ...) oriented to the substrate (2), and the grid is held in a plane parallel to the plane of the substrate (2), where the gaps (15, 16) in the separating walls (17, 18) open into the intermediate chamber (27) formed by the grid and substrate (2), and the targets (6, 7) of the cathodes (4, 5) in the compartments (12, 13) arranged either side of the compartment (14) are oriented to the side walls (23, 24) opposite the separating walls (17, 18) or to the base or cover part (25 or 26).

## Revendications

1. Dispositif de revêtement d'un substrat (2) à l'aide d'un procédé de dépôt chimique en phase vapeur CVD à plasma, ledit dispositif étant constitué d'une source de courant alternatif (3), par exemple un générateur moyenne fréquence, la source de courant alternatif étant reliée à deux cathodes (4, 5) qui incluent des aimants et qui coopèrent électriquement avec des cibles (6, 7), l'un (8) des pôles de la source de courant alternatif (3) étant raccordé à l'une (4) des cathodes et l'autre pôle (9) étant raccordé à l'autre cathode (5) chaque fois par l'intermédiaire d'une ligne d'alimentation (10, 11), **caractérisé en ce que** chacune des deux cathodes (4, 5) est disposée dans une chambre ou un compartiment propre (12, 13) et les deux compartiments formant entre eux un troisième compartiment (14), raccordé à une source de dépression (21), et étant reliés par des ouvertures (15, 16) ou des fentes ménagées dans les parois (17, 18) séparant les compartiments (12, 14 respectivement 13, 14) l'un de l'autre, le substrat (2), disposé dans le troisième compartiment (14), étant dirigé vers une source CVD qui est formée essentiellement d'une entrée de gaz réactif (19) et d'un collimateur (20).

2. Dispositif selon la revendication 1, **caractérisé en ce que** l'entrée de gaz réactif (19) de la source CVD est formée par un réseau constitué de tubes et comportant des buses (22, 22', ...) dirigées vers le substrat (2) et le réseau est maintenu dans un plan parallèle au plan du substrat (2), les fentes (15, 16) ménagées dans les parois de séparation (17, 18) débouchant dans l'espace intermédiaire (27) formé par le réseau et le substrat (2) et les cibles (6, 7) des cathodes (4, 5) dans les compartiments (12, 13), disposés des deux côtés du compartiment (14), étant orientées vers les parois latérales (23, 24), opposées aux parois de séparation (17, 18), ou la partie de fond ou la partie de couvercle (25 respectivement 26).
